# FASCICULE DE BREVET EUROPEEN

(11) **EP 3 357 083 B1**
(45) Date de publication et mention de la délivrance du brevet: **14.10.2020**
(21) Numéro de dépôt: 16777659.0
(22) Date de dépôt: 29.09.2016
(51) Int. Cl.: H01L 21/368, C23C 18/14

(54) **PROCÉDÉ DE DÉPÔT D'UNE COUCHE SEMI-CONDUCTRICE SUR UN FILM SEMI-CONDUCTEUR PAR PHOTOCATALYSE**
VERFAHREN ZUR ABSCHEIDUNG EINER HALBLEITENDEN SCHICHT AUF EINER HALBLEITERFILM DURCH FOTOKATALYSE
METHOD FOR DEPOSITING A SEMICONDUCTOR LAYER ON A SEMICONDUCTOR FILM BY PHOTOCATALYSIS

(30) Priorité: 02.10.2015 FR 1559379
(43) Date de publication de la demande: 08.08.2018
(73) Titulaire: Electricité de France, 75008 Paris (FR); Paris Sciences et Lettres - Quartier Latin, 75005 Paris (FR); Centre National de la Recherche Scientifique (CNRS), 75016 Paris (FR)
(72) Inventeur: LOONES, Nicolas, 92000 Nanterre (FR); GALLANTI, Serena, 75012 Paris (FR); NAGHAVI, Negar, 75016 Paris (FR); LINCOT, Daniel, 92160 Antony (FR)
(74) Mandataire: Plasseraud IP
(86) Numéro de dépôt international: PCT/EP2016/073336
(87) Numéro de publication internationale: WO 2017/055496

(56) Documents cités:
- JP-A- S59 123 239
- US-A1- 2014 220 724
- US-A1- 2015 171 255
- MORIYA K ET AL: "Characterization Of Cu2ZnSnS4 thin films prepared by photo-chemical deposition", PHYSICA STATUS SOLIDI (C), WILEY - VCH VERLAG, BERLIN, DE, vol. 3, no. 8, 4 septembre 2006 (2006-09-04), pages 2848-2852, XP009140208, ISSN: 1610-1634, DOI: 10.1002/PSSC.200669588 [extrait le 2006-08-31]

## Description

L'invention se rapporte au photo-dépôt de couches minces semi-conductrices sur des films semiconducteurs.

Ce genre de procédé est notamment utilisé dans le cadre de la fabrication de cellules solaires. Ces cellules comprennent généralement un film semi-conducteur disposant de propriétés photovoltaïques sur lequel est agencée une couche mince, dite couche tampon, qui forme généralement une couche d'interface entre le film semi-conducteur photovoltaïque et une fenêtre avant de la cellule.

A ce jour, il existe une grande variété de techniques permettant la formation de ces couches tampons, parmi lesquelles on recense les techniques dites par « voie humide » et qui reposent sur l'emploi d'un bain chimique.

Les techniques s'appuyant sur un tel bain procèdent généralement d'un dépôt chimique par chauffage via lequel le bain est chauffé, ce qui provoque le phénomène de croissance de la couche tampon. Un dépôt électrochimique, par lequel on applique à des électrodes immergées dans le bain une différence de potentiel, ce qui provoque la croissance de la couche tampon sur le film semi-conducteur agencé dans le bain chimique, peut également être utilisé.

Toutefois, ces deux techniques présentent des inconvénients.

Dans le cas du dépôt par chauffage, technique connue sous l'acronyme anglophone CBD, pour « Chemical Bath Deposition », les précurseurs soufrés de la couche qui sont employés tels que les thioamides et la thiourée présentent une cancérogénicité avérée ou suspectée. De plus ces bains utilisent un agent complexant tel que l'ammoniaque. Ce composé est volatile et tend à s'évaporer sous l'effet du chauffage du bain. Dans la mesure où sa concentration conditionne néanmoins le bon contrôle du dépôt, ce phénomène se traduit par une maitrise moins précise de la croissance de la couche. En outre, le chauffage du bain est très consommateur d'énergie, et le bain chimique doit être changé après chaque dépôt, de sorte que la quantité de déchets générés par cette technique est élevée.

Dans le cas du dépôt électrochimique, le substrat sur lequel la couche est déposée doit être conducteur. En outre, le matériel requis est onéreux, et il est généralement nécessaire de désoxygéner le bain chimique par bullage d'un gaz inerte, ce qui aboutit à une consommation de gaz importante et tend à complexifier le procédé de manière générale.

Aussi, l'invention vise à proposer un procédé de dépôt d'une couche mince qui permet d'obtenir des couches tampon d'excellente qualité et qui ne présente pas ces inconvénients.

A cet effet, l'invention concerne un procédé de dépôt d'une couche mince semi-conductrice comprenant au moins un sulfure d'une espèce métallique, le dépôt étant réalisé sur un film semi-conducteur agencé dans un bain chimique, le procédé comprenant les étapes de :
- préparer le bain chimique à partir d'au moins un précurseur soufré dudit sulfure d'une espèce métallique et d'un sel contenant ladite au moins une espèce métallique, le au moins un précurseur soufré contenant un thioacide de formule générale R-COSH, et
- former la couche mince par illumination du bain chimique et du film semi-conducteur au moyen d'une source de lumière.

Selon l'invention, la réunion des caractéristiques ci-dessus, et en particulier l'utilisation d'un thioacide en tant que précurseur soufré de la couche comprenant le sulfure métallique, a pour effet que la couche tampon peut être formée sous l'effet de la seule illumination du bain chimique et du film semi-conducteur par la source de lumière, et ne requiert pas le chauffage du bain chimique ou encore l'imposition d'une différence de potentiel entre deux électrodes qui s'y trouveraient. Le procédé selon l'invention est donc éminemment plus simple que les procédés connus. En outre, les thioacides sont des composés qui ne présentent pas le caractère cancérigène des thioamides ou de la thiourée.

Selon un aspect de l'invention, former la couche mince comprend :
- démarrer la croissance de la couche mince en initiant l'illumination, et
- faire cesser la croissance de la couche mince en interrompant l'illumination.

Selon un aspect de l'invention, former la couche mince est réalisé sensiblement sans chauffage du bain chimique.

Selon un aspect de l'invention, pour la formation de la couche mince par illumination, on interpose un écran de protection entre ladite source de lumière et le bain chimique, ledit écran de protection étant configuré pour prévenir les transferts thermiques entre la source de lumière et le bain chimique.

Selon un aspect de l'invention, la source de lumière est une source de lumière froide.

Selon un aspect de l'invention, former la couche mince est réalisé en l'absence d'un courant électrique ou d'une tension électrique appliquée au bain chimique.

Selon un aspect de l'invention, le film semi-conducteur est un film semi-conducteur de type p à propriétés photovoltaïques réalisé à partir d'un composé parmi Cu(In, Ga)(S, Se)₂, Cu₂(Zn, Sn)(S, Se)₄ ou CdTe.

Selon un aspect de l'invention, le film semi-conducteur est dépourvu de propriétés photovoltaïques.

Selon un aspect de l'invention, le film semi-conducteur est réalisé à partir de dioxyde de titane TiO₂. Selon un aspect de l'invention, le thioacide est de l'acide thioacétique.

Selon un aspect de l'invention, le au moins un sulfure d'une espèce métallique comprend au moins un élément du groupe formé par : CdS, ZnS In₂S₃,Ga₂S₃, In₂S₃, CoS, CuₓS, FeS, Ag₂S, SnS, PbS, HgS.

Selon un aspect de l'invention, le bain chimique à partir duquel on forme la couche mince comprend une concentration de sel métallique comprise entre 0,001 mol.L⁻¹ et 1 mol.L⁻¹, et une concentration de thioacide comprise entre 0,001 mol.L⁻¹ et 0,5 mol.L⁻¹.

Selon un aspect de l'invention, la source de lumière présente une puissance comprise entre 100 et 2000 mW/cm².

L'invention concerne par ailleurs un procédé de fabrication d'une cellule photovoltaïque comprenant une couche semi-conductrice à propriétés photovoltaïques, le procédé de fabrication comprenant l'obtention de ladite couche semi-conductrice à propriétés photovoltaïques et le dépôt, sur ladite couche semi-conductrice à propriétés photovoltaïques, d'une couche mince semi-conductrice au moyen du procédé tel que défini ci-dessus, de façon à former une jonction p-n de ladite cellule photovoltaïque.

L'invention concerne également une installation pour la mise en œuvre du procédé tel que défini ci-dessus, l'installation comprenant :
- un bain chimique contenant au moins un précurseur soufré du au moins un sulfure d'une espèce métallique et un sel contenant ladite au moins une espèce métallique, le au moins un précurseur soufré contenant un thioacide de formule générale R-COSH , et
- une source de lumière agencée pour illuminer le bain chimique.

Selon un aspect de l'invention, ladite installation est dépourvue de moyens de chauffage du bain chimique.

Selon un aspect de l'invention, l'installation comprend un écran de protection agencé entre ladite source de lumière et le bain chimique, ledit écran de protection étant configuré pour prévenir les transferts thermiques entre la source de lumière et le bain chimique.

Selon un aspect de l'invention, la source de lumière est une source de lumière froide.

Selon un aspect de l'invention, l'installation comprend un dispositif de déplacement configuré pour la mise en mouvement d'un support sur lequel est agencé le film semi-conducteur pour l'immersion du film semi-conducteur dans le bain chimique et pour la sortie du film semi-conducteur du bain chimique.

L'invention sera mieux comprise à la lecture de la description détaillée qui va suivre, donnée uniquement à titre d'exemple et faite en référence aux Figures annexées, sur lesquelles :
- Les Figures 1a et 1b illustrent une installation selon l'invention ;
- La Figure 2 est une illustration d'une installation selon une variante de l'invention ;
- La Figure 3 illustre un empilement comprenant une couche mince déposée via le procédé selon l'invention ;
- La Figure 4 illustre un procédé de dépôt selon l'invention ; et
- Les Figures 5a et 5b illustrent une couche mince de sulfure de Zinc déposée sur un film photovoltaïque de type CIGS via le procédé selon l'invention.

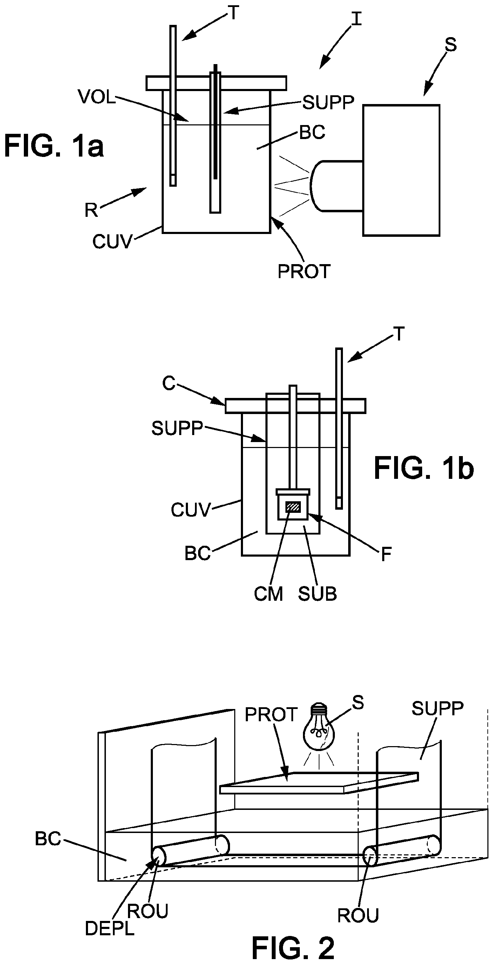

Les Figures 1a et 1b illustrent une installation I selon l'invention.

L'installation I est configurée pour la mise en œuvre du procédé de dépôt selon l'invention.

Le procédé en question porte sur le dépôt par photocatalyse d'une couche mince CM semi-conductrice comprenant au moins un sulfure d'une espèce métallique sur un film semi-conducteur F au moyen d'un bain chimique BC. Le ou les précurseurs soufrés utilisés, c'est-à-dire le ou les composés donneurs du soufre faisant par suite partie du ou des sulfures métalliques formés, comprennent un thioacide de formule générale R-COSH.

L'installation I comprend un réacteur R dans lequel le dépôt a lieu et dans lequel est agencé le bain chimique BC, et une source de lumière S. Comme décrit ci-après, la mise en marche de la source de lumière S a pour effet de déclencher la formation de la couche mince CM, et l'interruption de la source de lumière a pour effet de faire cesser la formation de la couche mince CM.

Le réacteur R comprend une cuve CUV délimitant intérieurement un volume VOL dans lequel le bain chimique BC est agencé. La portion de ce volume VOL qui ne correspond pas au bain chimique contient un gaz quelconque. Par exemple, il contient de l'air.

La cuve CUV est par exemple réalisée à partir d'un matériau transparent dans tout ou partie de la gamme de longueurs d'onde émise par la source de lumière S.

Par exemple, la cuve CUV est réalisée à partir de quartz.

Alternativement, seule la face de la cuve en regard de laquelle la source de lumière S est agencée est réalisée à partir du matériau transparent dans au moins une partie de cette gamme de longueurs d'onde. Dans l'exemple des Figures la et 1b, seule une face latérale de la cuve CUV est ainsi transparente.

Le réacteur R comprend en outre un couvercle C adapté pour obturer la cuve CUV.

Optionnellement, le réacteur R comprend en outre un thermomètre T porté par le couvercle C et dont une extrémité est plongée dans le bain chimique BC. Ainsi, le thermomètre T permet la mesure de la température du bain BC lors du procédé de dépôt.

A ce titre, on note que le principe de dépôt selon l'invention est indépendant, au moins sur une plage de températures donnée, de la température du bain chimique.

Le réacteur R comprend également un support SUPP fixé au couvercle C. Le support SUPP présente une partie immergée dans le bain chimique BC sur laquelle le film semi-conducteur F est agencé. En d'autres termes, le support SUPP forme un substrat SUB sur lequel le film F est agencé.

Le support SUPP se présente par exemple sous la forme d'une plaque réalisée à partir d'un matériau qui ne réagit pas avec le bain chimique BC lors du procédé de dépôt. Par exemple, le support SUPP est réalisé à partir de verre.

La source de lumière S est configurée pour émettre de la lumière en direction du bain chimique BC et du film F qui s'y trouve immergé. Par exemple, la source S est agencée en regard d'une face latérale de la cuve CUV.

La plage de longueurs d'onde d'émission de la source S est choisie en fonction du gap et de la nature du film semi-conducteur.

Le gap correspond à la différence d'énergie entre les bandes de conduction et de valence d'un matériau semi-conducteur. En d'autres termes, ici, le gap correspond à la quantité d'énergie à fournir au film semi-conducteur pour que la génération de paires électrons/trous impliquées dans la formation de la couche mince CM ait lieu.

Par exemple, la source S émet dans le domaine visible et dans les ultraviolets proches. Par exemple, la source S est une lampe au Xénon.

En outre, la source de lumière S présente une puissance conditionnée par la composition souhaitée pour la couche mince. Par exemple, cette puissance est comprise entre 100 et 2000 mW/cm². Par exemple, elle vaut sensiblement 950 mW/cm².

Avantageusement, dans certaines réalisations, la source S est une source de lumière froide, c'est-à-dire une source de lumière qui ne génère pas de chaleur. Ceci limite les transferts thermiques depuis la source S vers le bain chimique BC. En outre, ceci limite l'énergie perdue sous forme de chaleur et qui ne contribue pas à la réaction de formation de la couche mince CM.

Avantageusement, l'installation I comprend en outre un écran de protection PROT configuré pour limiter les transferts thermiques entre la source S et le bain chimique BC.

L'écran de protection PROT est interposé entre la source de lumière et le bain chimique. L'écran de protection est transparent dans tout ou partie de la gamme de longueurs d'onde émise par la source S, de sorte que l'illumination du bain puisse avoir lieu.

Dans le mode de réalisation des Figures la et 1b, l'écran de protection PROT est formé directement par l'une des faces latérales de la cuve CUV, en l'occurrence celle en regard de laquelle la source S est agencée.

Par « transferts thermiques », on entend ici en particulier les transferts thermiques résultant d'une éventuelle transmission de chaleur par convection, par exemple issue de l'élévation de température de la source S propagée au bain chimique par le milieu environnant, et les transferts thermiques par rayonnement provoqués par la lumière de la source S elle-même.

Avantageusement, l'écran de protection PROT est notamment configuré pour filtrer les rayonnements infrarouges émis par la source S en direction du bain chimique BC.

On note que le procédé de dépôt selon l'invention ne requiert pas d'apport en rayonnement infrarouge.

En variante, toutefois, l'installation I est dépourvue d'écran protecteur PROT.

La Figure 2 illustre une variante de l'installation I configurée pour la mise en œuvre du procédé de dépôt selon un mode dit « Roll-to-Roll », qui vient de l'anglais et peut être traduit par « rouleau à rouleau », ou encore « à déroulement continu ». Selon ce procédé, le dépôt de la couche mince CM est réalisé de manière continue.

Selon cette variante, l'installation I comprend un dispositif de déplacement DEPL pour la mise en mouvement du support SUPP, et plus spécifiquement pour son immersion et sa sortie successives du bain chimique BC.

Le dispositif de déplacement DEPL comprend deux rouleaux ROU agencés sensiblement horizontalement et parallèlement l'un à l'autre dans le bain chimique BC. Les rouleaux ROU sont connectés à un moteur (non représenté) sous l'effet duquel ils pivotent autour de leur axe respectif pour déplacer le support SUPP.

En outre, le support SUPP sur lequel le film F est agencé est continu et souple. Par ailleurs, il est au contact des rouleaux ROU de sorte que la rotation de ces derniers fasse défiler chaque portion du support SUPP depuis l'amont du bain BC vers le bain BC, puis du bain vers l'aval du bain BC.

On note que le film F qui est agencé sur le support SUPP est lui-même continu en tout ou partie. Alternativement ou parallèlement, il est discontinu en tout ou partie et se présente sous la forme de plaques semi-conductrices.

Dans cette variante, la source S comprend par exemple un panneau de diodes électroluminescentes DEL surplombant le bain chimique BC et orienté en direction du bain chimique BC. Une telle source S permet de réaliser l'illumination d'une grande surface du support avec une puissance maîtrisée, et permet ainsi de réaliser le dépôt de la couche mince CM sur le film F de manière optimale.

En outre, le bain chimique est avantageusement au contact de l'air.

Par ailleurs, l'écran de protection PROT est indépendant des parois du réacteur R, c'est-à-dire qu'il n'en forme pas une paroi. Il est agencé entre la source S et le bain chimique BC. Il est par exemple disposé horizontalement au-dessus du bain chimique BC.

Le procédé selon l'invention va maintenant être décrit en référence aux Figures.

Comme indiqué précédemment, il vise au dépôt de la couche mince semi-conductrice CM sur un film F semi-conducteur, notamment pour la fabrication de cellules photovoltaïques.

Dans ce contexte d'utilisation, le film semi-conducteur F est un film semi-conducteur de type p à propriétés photovoltaïques. Il s'agit avantageusement d'un film F semi-conducteur à propriétés photovoltaïques réalisé à partir d'un composé. Ce composé est par exemple choisi parmi Cu(In, Ga)(S, Se)₂, Cu₂(Zn, Sn)(S, Se)₄ ou CdTe. En outre, le dépôt de la couche mince CM vise alors à la formation d'une jonction p-n de la cellule solaire. On remarque que le premier composé a une structure cristalline de type chalcopyrite.

Dans l'exemple des Figures, le film F est de type CIGS, pour Cuivre Indium Gallium Sélénium, c'est-à-dire un film Cu(In, Ga)Se₂.

Toutefois, alternativement, le film F est un film semi-conducteur dépourvu de propriétés photovoltaïques. Avantageusement, il s'agit alors d'un film réalisé à partir de dioxyde de titane TiO₂.

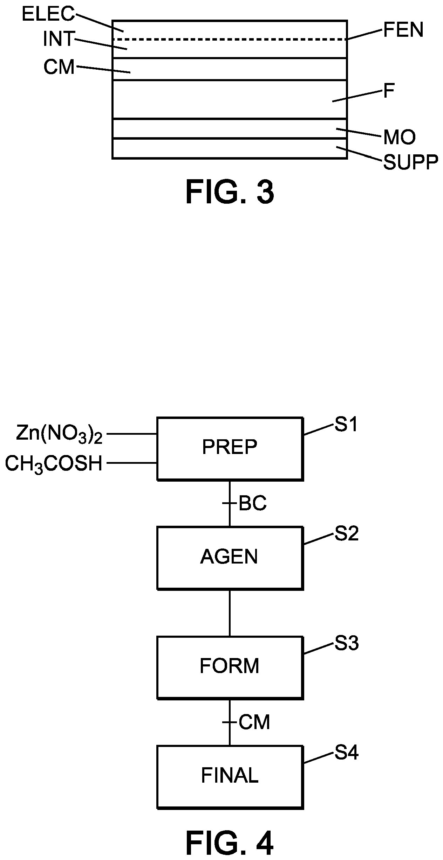

La Figure 3, qui se rapporte à la fabrication de cellules solaires, illustre l'empilement que l'on vise à obtenir sur le support SUPP, et qui forme un constituant d'une cellule solaire.

Cet empilement comprend une couche de Molybdène MO agencée sur le support SUPP. Le film F, ici un film de type CIGS, est agencé sur le support SUPP par l'intermédiaire de cette couche de Molybdène. La couche mince CM est agencée sur le film F. Elle forme une couche tampon de l'empilement sur laquelle est agencée une fenêtre transparente FEN. Cette fenêtre comprend par exemple une première couche intrinsèque INT visant à éviter les courts-circuits, et une électrode avant ELEC réalisée à partir d'un oxyde métallique, par exemple de l'oxyde de Zinc, et fortement dopée, par exemple avec de l'Aluminium.

Le procédé selon l'invention est spécifiquement adapté pour le dépôt de la couche mince CM semi-conductrice qui forme la couche tampon entre l'empilement CIGS et la fenêtre transparente FEN.

Toutefois, bien entendu, le procédé selon l'invention peut être appliqué dans d'autres contextes.

La Figure 4 illustre les étapes du procédé selon l'invention dans une réalisation dans laquelle la couche mince CM est réalisée à partir de sulfure de zinc ZnS, le film F étant de type CIGS, et l'empilement souhaité est destiné à une application photovoltaïque.

Dans cette réalisation, la couche mince CM est essentiellement composée de ZnS. Par « essentiellement », on entend que la couche mince CM comprend principalement du ZnS mais peut éventuellement contenir des traces d'autres composés, tels que certains oxydes ou hydroxydes.

Aussi, lors d'une étape initiale S1 du procédé, on prépare le bain chimique BC.

Lors de cette étape S1, on forme le bain chimique BC à partir d'un sel métallique fournissant l'espèce métallique du sulfure de la couche mince CM. Dans cet exemple, il s'agit de sel de Zinc. Par exemple, le sel de Zinc en question est du nitrate de Zinc de formule générale Zn(NO₃)₂.

Avantageusement, la concentration du sel métallique dans le bain chimique BC est comprise entre 0,001 mol.L⁻¹ et 1 mol.L⁻¹. Par exemple, cette concentration est sensiblement de 0,05 mol.L⁻¹.

En outre, on forme le bain chimique également à partir d'un thioacide. Autrement dit, le bain comprend un thioacide.

Les thioacides sont des composés de formule générale R-COSH. Par exemple, R désigne un hydrogène ou un groupe organique.

On remarque que cette formule générale englobe les composés dits S-thioacides, de type R-C(=O)SH, ainsi que les composés dits O-thioacides, de type R-C(=S)OH. Ces formes S et O sont des formes prototropes. Pour les thioacides, c'est la forme S qui est généralement prépondérante par rapport à la forme O.

En outre, le terme thioacide est généralement traduit par « thiocarboxylic acid » en anglais, qui peut être traduit littéralement par l'expression acide thiocarboxylique.

Dans cette réalisation, le thioacide utilisé est l'acide thioacétique. Il présente une formule générale CH₃COSH.

Avantageusement, la concentration du bain BC en thioacide est comprise entre 0,001 mol.L⁻¹ et 0,5 mol.L⁻¹ Par exemple, cette concentration est sensiblement de 0,01 mol.L⁻¹

Avantageusement, le bain chimique BC comprend essentiellement le thioacide et le sel métallique ci-dessus. Autrement dit, ils en forment les composants principaux, d'autres composés pouvant toutefois être présents sous forme de traces non-intentionnelles.

Alternativement, le bain chimique BC comprend en outre au moins un composé configuré pour améliorer les performances du procédé. Par exemple, le bain chimique BC comprend alors un complexant chimique.

Toutefois, on note que la présence de tels composés n'est pas nécessaire à la mise en œuvre du procédé selon l'invention.

En pratique, pour la préparation du bain chimique BC, ses constituants sont mélangés et le bain chimique obtenu est homogénéisé, par exemple par la mise en mouvement d'un agitateur mécanique agencé dans le bain.

Lors d'une étape S2, on agence le film F disposé sur le support dans le bain chimique BC.

Pour ce faire, on obtient initialement le support SUPP sur lequel le film F est préalablement formé. Dans le cas d'un film semi-conducteur à propriétés photovoltaïques, par exemple de type CIGS, on forme préalablement le film F selon tout procédé connu.

Par exemple, on le forme par un procédé de co-évaporation sous vide dans lequel on dépose un empilement de couches de Cuivre, Indium et Gallium, le dépôt de cet empilement étant suivi d'une étape de sélénisation pour apporter le Sélénium à l'empilement et former la structure définitive du film F.

Une fois le film F formé sur la couche de Molybdène MO et le support SUPP, on agence le support SUPP dans le bain chimique BC.

Dans la réalisation des Figures la et 1b, pour ce faire, on ferme la cuve CUV avec le couvercle C de sorte que le film F porté par le support SUPP soit immergé dans le bain chimique BC.

Dans la réalisation de la Figure 2, on actionne les rouleaux pour faire défiler le support SUPP de sorte que le film F, du moins sa portion initiale (au sens de la direction de défilement du support SUPP), vienne à être immergé dans le bain BC.

Lors d'une étape S3, on forme la couche mince CM sur le film F.

Pour ce faire, on met en marche la source de lumière S de sorte que le bain chimique BC et le film F qui s'y trouve immergé soient illuminés par la source de lumière. Cette illumination a pour effet de faire croître la couche mince CM sur le film F.

Le principe de la réaction se produisant sous l'effet de la source de lumière S est le suivant.

L'éclairement du film semi-conducteur F a pour effet de créer des paires électrons-trous à la surface du film semi-conducteur. Ces paires conduisent à l'oxydo-réduction des espèces présentes dans le bain chimique, ce qui aboutit à la formation à la surface du film F d'un sulfure de formule générale MₓS_{y}, ici de formule spécifique ZnS, qui constitue la couche mince CM.

Cette réaction dure alors tant que la source de lumière S est maintenue allumée et éclaire le bain chimique et le film semi-conducteur F. A l'inverse, elle s'interrompt quand la source S est éteinte.

La réaction est rendue possible par les propriétés des thioacides, ainsi que par les propriétés semi-conductrices du film F et de la couche mince CM.

On note qu'une fois une certaine épaisseur de couche mince CM déposée, la réaction en jeu est la même que celle précédemment décrite, mais le dépôt s'effectue alors sur l'épaisseur de couche mince précédemment déposée, et non plus sur le film F comme initialement.

Une fois la couche mince CM présentant l'épaisseur souhaitée, la source de lumière S est éteinte. Ceci a pour effet de provoquer l'arrêt du mécanisme ci-dessus et l'arrêt de la croissance de la couche mince CM.

Par exemple, l'épaisseur en question est de l'ordre de quelques dizaines de nanomètres, et vaut par exemple sensiblement 30 nm.

La durée de l'illumination est comprise entre quelques minutes, par exemple 5 minutes, et plusieurs dizaines de minutes, par exemple 1 heure, en fonction de l'épaisseur de la couche mince CM souhaitée. Dans certaines réalisations, le temps de dépôt peut être supérieur à 1 heure, par exemple lorsque l'épaisseur recherchée est importante.

Une fois la couche mince CM formée, on l'extrait du bain chimique. Dans la réalisation des Figures la et 1b, on ôte le couvercle C et le support SUPP qui y est fixé. Dans la réalisation de la Figure 2, on fait défiler le support au moyen des rouleaux ROU de façon à faire sortir la couche mince CM du bain chimique. Avantageusement, ceci a parallèlement pour effet d'immerger une nouvelle portion du film F dans le bain chimique BC pour la formation d'une couche mince CM sur cette portion.

Cette étape de formation de la couche mince CM est réalisée substantiellement sans chauffage du bain chimique. Par « substantiellement sans chauffage du bain chimique », on entend qu'on mène cette étape avec le bain chimique à température ambiante. Par exemple, la température du bain est alors comprise entre 15°C et 30°C. En outre, on n'a pas recours à un dispositif de chauffage dont la fonction prévue est le chauffage du bain chimique BC.

Ainsi, le procédé selon l'invention se distingue fondamentalement de la technique dite CBD, dans laquelle la croissance de la couche mince CM résulte spécifiquement du chauffage du bain chimique.

On note qu'au cours de cette étape, il existe tout au plus un phénomène de chauffage marginal du bain chimique lié à l'utilisation de la source de lumière S. Toutefois, ce phénomène n'est pas intentionnel, et le chauffage du bain sous l'effet de la source S est marginal, voir intégralement évité, via l'écran de protection PROT.

A ce titre, un éventuel chauffage du bain chimique n'est pas souhaitable dans la mesure où les thioacides tendent à s'hydrolyser sous l'effet de la chaleur.

Aussi, l'utilisation avantageuse de l'écran de protection PROT et/ou d'une lumière froide S permet de réduire le risque d'occurrence de cette hydrolyse.

En outre, la durée de la phase de dépôt, qui est relativement courte, contribue à prévenir tout phénomène de chauffage notable du bain sous l'effet de la source S.

Ces aspects afférents à l'absence de chauffage délibéré du bain chimique dans le cadre de l'invention ont pour effet que le procédé selon l'invention consomme moins d'énergie.

En outre, le procédé selon l'invention peut s'affranchir des produits complexants tels l'ammoniaque qui sont requis pour la formation de la couche mince dans les techniques CBD.

En outre, le procédé selon l'invention ne repose pas sur l'emploi d'électrodes immergées dans le bain chimique BC et auxquelles une différence de potentiel est appliquée. En cela, le procédé de l'invention se distingue de la technique d'électrodéposition et est donc beaucoup plus simple et moins coûteux.

On note également que le dépôt de la couche mince CM est réalisé alors que le bain chimique est au contact de l'air, et qu'il ne requiert pas la présence d'un gaz inerte ou encore la mise sous vide du réacteur R. En outre, avantageusement, cette étape est réalisée en l'absence d'agitation du bain chimique visant à l'homogénéiser.

Lors d'une étape S4 subséquente, on forme la fenêtre transparente FEN sur la couche mince CM obtenue lors de l'étape S3.

Par exemple, la première partie de la fenêtre (couche INT sur la Figure 3) est formée par pulvérisation réactive, technique connue sous le nom de « sputtering » en anglais, ou encore par une technique connue sous le nom anglophone de « Métal Organic Chemical Vapor Deposition », ou encore par une technique connue sous le nom anglophone de « Atomic Layer Chemical Vapor Deposition ».

Une fois la fenêtre formée, l'empilement obtenu fait optionnellement l'objet d'un post-traitement, comprenant par exemple une ou plusieurs illuminations de l'empilement et un recuit de l'empilement. Par exemple, un post-traitement envisageable comprend une illumination d'une heure, puis un recuit à 200°C pendant 10 minutes, puis à nouveau une illumination pendant 1h.

Le procédé selon l'invention a par exemple été mis en œuvre sur un film semi-conducteur de type CIGS dans l'installation des Figures la et 1b, la couche mince formée CM étant réalisée à partir de sulfure de Zinc ZnS et présentant une épaisseur de l'ordre de 30 nm. Le thioacide utilisé était de l'acide thioacétique. Le film F utilisé était un film de forme carrée de côté valant environ 2,5 cm.

Les concentrations du bain chimique étaient de 0,01 mol.L⁻¹ pour l'acide thioacétique et de 0,05 mol.L⁻¹ pour le nitrate de Zinc. La source de lumière employée était une lampe à Xenon d'environ 950 mW/cm² de puissance. La formation de la couche mince CM par photocatalyse a duré environ 20 minutes.

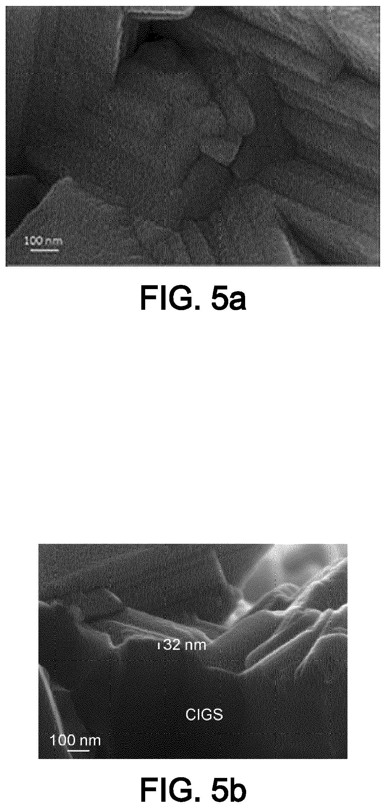

Les Figures 5a et 5b illustrent des images du résultat obtenu au microscope électronique à balayage.

La Figure 5a est une vue de la surface du dépôt de ZnS formant la couche mince CM, et la Figure 5b est une vue en coupe de ce dépôt. On constate sur ces Figures que le dépôt est très couvrant, dense et homogène sur toute la surface du film F. En outre, il ne contient pas d'agrégat.

On note que, de manière connue, certains atomes de soufre de cette couche mince CM peuvent subir une substitution et se voir remplacés par des atomes d'oxygène ou des espèces de type OH⁻, de sorte que la couche mince CM obtenue peut présenter des traces d'oxygène ou d'hydroxydes.

Le procédé selon l'invention présente de nombreux avantages.

En particulier, il permet d'obtenir des couches minces d'excellente qualité.

En effet, le tableau ci-dessous compare une cellule solaire réalisée à partir d'un empilement dont la couche mince en ZnS a été déposée selon le procédé ci-dessus à une cellule solaire dont la couche mince est en sulfure de Cadmium CdS et a été déposée selon un procédé de l'art antérieur, les autres composants de l'empilement étant identiques à ceux de la cellule solaire dont la couche mince CM a été déposée via le procédé selon l'invention.

| **Couche Tampon** | **Eff (%)** | **FF (%)** | **V_{OC} (mV)** | **J_{SC} (mA/cm₂)** |
|---|---|---|---|---|
| CdS | 13,8 | 73,7 | 610 | 30,1 |
| ZnS selon l'invention | 14 | 73,8 | 635 | 29,8 |

L'indicateur Eff quantifie le rendement de la cellule solaire en question. V_{OC} quantifie la tension aux bornes de la cellule lorsque celle-ci est en circuit ouvert. J_{SC} quantifie le courant de court-circuit, c'est-à-dire le courant qui traverse la cellule lorsque celle-ci est en court-circuit. FF correspond au facteur de forme, c'est-à-dire au ratio entre la puissance maximale de la cellule et le produit J_{SC}^{∗}V_{OC}.

Le procédé selon l'invention a ainsi permis d'augmenter le rendement de la cellule solaire vis-à-vis d'un dépôt classique de la couche tampon d'environ 0,2 point.

Par ailleurs, du fait que la technique proposée par l'invention procède d'une photocatalyse qui ne nécessite pas le chauffage du bain et/ou l'imposition d'une différence de potentiel à des électrodes immergées dans le bain, la quantité d'énergie consommée par l'invention est bien plus faible que pour les procédés connus.

En outre, comparativement à des techniques reposant sur de l'électrochimie photoassistée, le procédé selon l'invention permet d'éviter la formation usuellement observée d'agrégats, par exemple de zinc, dans la couche déposée via ces techniques. Ces agrégats présentent une épaisseur importante et contribuent à une diminution de la performance des cellules solaires correspondantes.

Par ailleurs, dans la mesure où la croissance de la couche mince est entièrement conditionnée par l'illumination, la cessation de l'illumination a pour effet de mettre un terme à la croissance de la couche de dépôt. Ainsi, le bain chimique est réutilisable.

En outre, du fait des phénomènes physico-chimiques en jeu, la croissance de la couche de dépôt n'a lieu qu'au niveau du film semi-conducteur, et non également sur toutes les surfaces du réacteur (par exemple ses parois) qui sont en contact avec le bain chimique, comme avec les procédés connus.

En outre, le procédé n'implique pas le recours à des composés de cancérigénicité avérée tels que les thioamides ou la thiourée.

Par ailleurs, l'épaisseur de la couche déposée est aisément contrôlée, et ce pour des temps de dépôt courts.

On note par ailleurs que des techniques de dépôt de couche mince par photochimie ont par ailleurs été envisagées dans certains contextes. Ces techniques de dépôt reposent notamment sur l'emploi de thiosulfates en tant que précurseurs soufrés.

L'emploi de ce type de composés se traduit par de nombreuses contraintes sur la mise en œuvre du procédé.

En effet, la formation d'une couche mince par cette technique impose l'utilisation de rayonnements très énergétiques, par exemple des ultraviolets. Or, du fait de la tendance de la phase aqueuse du bain à absorber ces rayonnements, la configuration spatiale de la source de rayonnement et du bain chimique est fortement contrainte. On doit ainsi observer un très faible espacement entre le bain et la source pour que la réaction puisse marcher.

En outre, les thiosulfates ont une tendance marquée à la dismutation en milieu acide, de sorte que le pH du bain chimique doit faire l'objet d'un contrôle fin. En outre, les valeurs de pH compatibles avec la stabilité des thiosulfates tendent à limiter les sels métalliques pouvant être employés du fait de l'interférence du pH avec le produit de solubilité de ces sels. En outre, le rayonnement appliqué au bain doit faire l'objet d'un contrôle visant à le rendre intermittent de façon à limiter la quantité de métal dans la couche métallique. Enfin, le bain chimique doit faire l'objet d'une agitation permanente, ce qui se traduit par une reproductibilité dégradée du procédé de dépôt selon cette technique.

D'autres modes de réalisation de l'invention sont par ailleurs envisageables.

En particulier, le procédé ci-dessus a été décrit dans le cadre d'une réalisation particulière dans laquelle le thioacide utilisé est de l'acide thioacétique. Toutefois, en variante, un thioacide quelconque peut être utilisé. Par exemple, on utilise un thioacide de formule CH₃CH₂COSH, ou encore un thioacide de formule générale R-CH₂COSH.

En outre, le bain chimique a été décrit comme comprenant un seul thioacide. Alternativement, on prépare le bain chimique BC à partir d'au moins deux thioacides différents.

Par ailleurs, le sel métallique employé dans le procédé ci-dessus est un nitrate de zinc. Toutefois, d'autres composés fournissant le métal du sulfure métallique de la couche mince CM sont envisageables. En particulier, on peut utiliser un sulfate métallique, un chlorure métallique, un bromure métallique, un iodure métallique ou un oxyde de ceux-ci. On peut également envisager l'utilisation de carboxylates, de nitrites, de carbonates, d'hydrogénocarbonates, d'hydroxydes, etc.

En outre, le sulfure de la couche mince CM a été décrit comme réalisé à partir de sulfure de zinc. Alternativement, d'autres sulfures, tels que par exemple des oxysulfures, sont envisageables, dès lors que leur produit de solubilité est suffisamment faible. Par exemple, le produit de solubilité en question est inférieur à 10⁻¹⁰.

Les composés envisagés pour la couche mince CM comprennent ainsi par exemple CdS, ZnS, In₂S₃, Ga₂S₃, In₂S₃, CoS, CuₓS, FeS, Ag₂S, SnS, PbS, HgS.

Par ailleurs, la couche mince peut comprendre une pluralité de sulfures métalliques différents. Par exemple, elle comprend du sulfure de Zinc et un ou plusieurs des composés ci-dessus.

En outre, en variante, la source de lumière S est formée par l'extrémité d'un guide de lumière couplé à un élément photoémissif. Le guide de lumière est configuré pour acheminer la lumière émise par l'élément photoémissif et ayant pénétré dans le guide de lumière jusqu'au bain chimique.

Cette réalisation a pour effet d'autoriser une grande souplesse en termes de configuration géométrique relative de la source et du bain.

En outre, une telle réalisation permet d'économiser de l'énergie car l'emploi d'un guide de lumière permet de focaliser la lumière de la source de lumière S sur une surface d'aire minimale. Aussi, avantageusement, l'installation I selon cette variante est mise en œuvre pour la fabrication de couches minces sur un film F de petites dimensions, par exemple inférieures à 1 cm².

Dans cette réalisation, avantageusement, la source de lumière S est alors agencée directement dans le bain chimique au plus près du film F, ce qui optimise l'énergie dépensée pour la formation de la couche mince CM.

Le ou les guides de lumière se présentent par exemple sous la forme de fibres optiques couplées optiquement à l'élément photoémissif. L'élément en question est par exemple une diode électroluminescente.

Par ailleurs, dans une autre variante, l'installation est dépourvue de support SUPP. Dans cette variante, le film F est par exemple posé sur le fond du réacteur R.

## Revendications

1. Procédé de dépôt d'une couche mince semi-conductrice (CM) comprenant au moins un sulfure d'une espèce métallique, le dépôt étant réalisé sur un film semi-conducteur (F) agencé dans un bain chimique (CM), le procédé comprenant les étapes de :
- préparer (S1) le bain chimique (BC) à partir d'au moins un précurseur soufré dudit sulfure d'une espèce métallique et d'un sel contenant ladite au moins une espèce métallique, le au moins un précurseur soufré contenant un thioacide de formule générale R-COSH, englobant les formes prototropes de type R-C(=O)SH et de type R-C(=S)OH, où R désigne un hydrogène ou un groupe organique, et
- former (S3) la couche mince (CM) par illumination du bain chimique (BC) et du film semi-conducteur (F) au moyen d'une source de lumière (S).

2. Procédé selon la revendication 1, dans lequel former (S3) la couche mince comprend :
- démarrer la croissance de la couche mince en initiant l'illumination, et
- faire cesser la croissance de la couche mince en interrompant l'illumination.

3. Procédé selon l'une quelconque des revendications précédentes, dans lequel former (S3) la couche mince (CM) est réalisée sans chauffage du bain chimique (BC).

4. Procédé selon l'une quelconque des revendications précédentes, dans lequel, pour la formation de la couche mince (CM) par illumination, on interpose un écran de protection (PROT) entre ladite source de lumière (S) et le bain chimique (BC), ledit écran de protection (PROT) étant configuré pour prévenir les transferts thermiques entre la source de lumière (S) et le bain chimique (BC).

5. Procédé selon l'une quelconque des revendications précédentes, dans lequel la source de lumière (S) est une source de lumière froide.

6. Procédé selon l'une quelconque des revendications précédentes, dans lequel former (S3) la couche mince est réalisé en l'absence d'un courant électrique ou d'une tension électrique appliquée au bain chimique (BC).

7. Procédé selon l'une quelconque des revendications précédentes, dans lequel le film semi-conducteur (F) est un film semi-conducteur de type p à propriétés photovoltaïques réalisé à partir d'un composé parmi Cu(In, Ga)(S, Se)₂, Cu₂(Zn, Sn)(S, Se)₄ ou CdTe.

8. Procédé selon l'une quelconque des revendications 1 à 6, dans lequel le film semi-conducteur (F) est dépourvu de propriétés photovoltaïques.

9. Procédé selon la revendication 8, dans lequel le film semi-conducteur est réalisé à partir de dioxyde de titane TiO₂.

10. Procédé selon l'une quelconque des revendications précédentes, dans lequel le thioacide est de l'acide thioacétique.

11. Procédé selon l'une quelconque des revendications précédentes, dans lequel le au moins un sulfure d'une espèce métallique comprend au moins un élément du groupe formé par : CdS, ZnS In₂S₃,Ga₂S₃, In₂S₃, CoS, CuₓS, FeS, Ag₂S, SnS, PbS, HgS.

12. Procédé selon l'une quelconque des revendications précédentes, dans lequel le bain chimique (BC) à partir duquel on forme la couche mince (CM) comprend une concentration de sel métallique comprise entre 0,001 mol.L⁻¹ et 1 mol.L⁻¹, et une concentration de thioacide comprise entre 0,001 mol.L⁻¹ et 0,5 mol.L⁻¹.

13. Procédé selon l'une quelconque des revendications précédentes, dans lequel la source de lumière (S) présente une puissance comprise entre 100 et 2000 mW/cm².

14. Procédé de fabrication d'une cellule photovoltaïque comprenant une couche semi-conductrice à propriétés photovoltaïques, le procédé de fabrication comprenant l'obtention de ladite couche semi-conductrice à propriétés photovoltaïques et le dépôt, sur ladite couche semi-conductrice à propriétés photovoltaïques, d'une couche mince semi-conductrice au moyen du procédé selon l'une quelconque des revendications 1 à 13, de façon à former une jonction p-n de ladite cellule photovoltaïque.

15. Installation pour la mise en œuvre du procédé selon l'une quelconque des revendications précédentes, l'installation comprenant :
- un bain chimique (BC) contenant au moins un précurseur soufré du au moins un sulfure d'une espèce métallique et un sel contenant ladite au moins une espèce métallique, le au moins un précurseur soufré contenant un thioacide de formule générale R-COSH, englobant les formes prototropes de type R-C(=O)SH et de type R-C(=S)OH, où R désigne un hydrogène ou un groupe organique, et
- une source de lumière (S) agencée pour illuminer le bain chimique (BC).

## Patentansprüche

1. Verfahren zur Abscheidung einer dünnen Halbleiterschicht (CM), die mindestens ein Sulfid einer Metallspezies umfasst, wobei die Abscheidung auf einem Halbleiterfilm (F) erfolgt, der in einem chemischen Bad (CM) angeordnet ist, wobei das Verfahren folgende Schritte umfasst:
- Herstellen (S1) des chemischen Bads (BC) aus mindestens einer Schwefelvorläuferverbindung des Sulfids einer Metallspezies und aus einem Salz, das die mindestens eine Metallspezies enthält, wobei die mindestens eine Schwefelvorläuferverbindung eine Thiosäure mit der allgemeinen Formel R-COSH enthält, die die prototropen Formen vom Typ R-C(=O)SH und vom Typ R-C(=S)OH umfasst, wobei R einen Wasserstoff oder eine organische Gruppe bezeichnet,
und
- Bilden (S3) der dünnen Schicht (CM) durch Beleuchten des chemischen Bads (BC) und des Halbleiterfilms (F) mit einer Lichtquelle (S).

2. Verfahren nach Anspruch 1, wobei das Bilden (S3) der dünnen Schicht umfasst:
- Veranlassen des Wachstums der dünnen Schicht durch Beginnen mit dem Beleuchten und
- Beenden des Wachstums der dünnen Schicht durch Abbrechen des Beleuchtens.

3. Verfahren nach einem der vorhergehenden Ansprüche, wobei das Bilden (S3) der dünnen Schicht (CM) ohne Erwärmen des chemischen Bads (BC) erfolgt.

4. Verfahren nach einem der vorhergehenden Ansprüche, wobei zum Bilden der dünnen Schicht (CM) durch Beleuchten eine Schutzvorrichtung (PROT) zwischen der Lichtquelle (S) und dem chemischen Bad (BC) angeordnet wird, wobei die Schutzvorrichtung (PROT) so eingerichtet ist, dass sie den Wärmetransport zwischen der Lichtquelle (S) und dem chemischen Bad (BC) verhindert.

5. Verfahren nach einem der vorhergehenden Ansprüche, wobei die Lichtquelle (S) eine Kaltlichtquelle ist.

6. Verfahren nach einem der vorhergehenden Ansprüche, wobei das Bilden (S3) der dünnen Schicht ohne elektrischen Strom oder Anlegen einer elektrischen Spannung an das chemische Bad (BC) erfolgt.

7. Verfahren nach einem der vorhergehenden Ansprüche, wobei der Halbleiterfilm (F) ein p-Halbleiterfilm mit photovoltaischen Eigenschaften ist, der aus einer Verbindung aus Cu(In, Ga) (S, Se)₂, Cu₂(Zn, Sn) (S, Se)₄ oder CdTe hergestellt ist.

8. Verfahren nach einem der Ansprüche 1 bis 6, wobei der Halbleiterfilm (F) keine photovoltaischen Eigenschaften aufweist.

9. Verfahren nach Anspruch 8, wobei der Halbleiterfilm aus Titandioxid TiO₂ hergestellt ist.

10. Verfahren nach einem der vorhergehenden Ansprüche, wobei die Thiosäure Thioessigsäure ist.

11. Verfahren nach einem der vorhergehenden Ansprüche, wobei das mindestens eine Sulfid einer Metallspezies mindestens ein Element aus der Gruppe umfasst, die gebildet ist aus: CdS, ZnS, In₂S₃, Ga₂S₃, In₂S₃, CoS, CuₓS, FeS, Ag₂S, SnS, PbS, HgS.

12. Verfahren nach einem der vorhergehenden Ansprüche, wobei das chemische Bad (BC), aus dem die dünne Schicht (CM) gebildet wird, eine Konzentration an Metallsalz zwischen 0,001 mol.l⁻¹ und 1 mol.l⁻¹ und eine Konzentration an Thiosäure zwischen 0,001 mol.l⁻¹ und 0,5 mol.l⁻¹ umfasst.

13. Verfahren nach einem der vorhergehenden Ansprüche, wobei die Lichtquelle (S) eine Leistung zwischen 100 und 2000 mW/cm² aufweist.

14. Verfahren zur Herstellung einer photovoltaischen Zelle, die eine Halbleiterschicht mit photovoltaischen Eigenschaften umfasst, wobei das Herstellungsverfahren das Erhalten der Halbleiterschicht mit photovoltaischen Eigenschaften und das Abscheiden, auf der Halbleiterschicht mit photovoltaischen Eigenschaften, einer dünnen Halbleiterschicht mit dem Verfahren nach einem der Ansprüche 1 bis 13 umfasst, damit ein p-n-Übergang der photovoltaischen Zelle gebildet wird.

15. Anlage zur Durchführung des Verfahrens nach einem der vorhergehenden Ansprüche, wobei die Anlage umfasst:
- ein chemisches Bad (BC), das mindestens eine Schwefelvorläuferverbindung des mindestens eines Sulfids einer Metallspezies und ein Salz enthält, das die mindestens eine Metallspezies enthält, wobei die mindestens eine Schwefelvorläuferverbindung eine Thiosäure mit der allgemeinen Formel R-COSH enthält, die die prototropen Formen vom Typ R-C(=O)SH und vom Typ R-C(=S)OH umfasst, wobei R einen Wasserstoff oder eine organische Gruppe bezeichnet, und
- eine Lichtquelle (S), die zum Beleuchten des chemischen Bads (BC) angeordnet ist.

## Claims

1. A method for depositing a thin semiconductor layer (CM) comprising at least one sulphide of a metal species, the deposition being carried out on a semiconductor film (F) arranged in a chemical bath (CM), the method comprising the steps of:
- preparing (SI) the chemical bath (BC) from at least one sulphur precursor of said sulphide of a metal species and of a salt containing said at least one metal species, the at least one sulphur precursor containing a thioacid of general formula R-COSH encompassing prototropic forms of R-C(=O)SH type and of R-C(=S)OH type, where R designates a hydrogen or an organic group, and
- forming (S3) the thin layer (CM) by illumination of the chemical bath (BC) and of the semiconductor film (F) by means of a light source (S).

2. The method according to claim 1, wherein forming (S3) the thin layer comprises:
- starting the growth of the thin layer by initiating illumination, and
- stopping the growth of the thin layer by interrupting the illumination.

3. The method according to any one of the preceding claims, wherein forming (S3) the thin layer (CM) is performed without heating the chemical bath (BC).

4. The method according to any one of the preceding claims, wherein, for forming the thin layer (CM) by illumination, a protective screen (PROT) is interposed between said light source (S) and the chemical bath (BC), said protective screen (PROT) being configured to prevent heat transfers between the light source (S) and the chemical bath (BC).

5. The method according to any one of the preceding claims, wherein the light source (S) is a cold light source.

6. The method according to any one of the preceding claims, wherein forming (S3) the thin layer is performed in the absence of an electric current or an electric voltage applied to the chemical bath (BC).

7. The method according to any one of the preceding claims, wherein the semiconductor film (F) is a p-type semiconductor film with photovoltaic properties made from a compound among Cu(In, Ga)(S, Se)₂, Cu₂(Zn, Sn)(S, Se)₄ or CdTe.

8. The method according to any one of claims 1 to 6, wherein the semiconductor film (F) is devoid of photo voltaic properties.

9. The method according to claim 8, wherein the semiconductor film is made from titanium dioxide TiO₂.

10. The method according to any one of the preceding claims, wherein the thioacid is the thioacetic acid.

11. The method according to any one of the preceding claims, wherein the at least one sulphide of a metal species comprises at least one element of the group formed of: CdS, ZnS, In₂S₃, Ga₂S₃, In₂S₃, CoS, CuₓS, FeS, Ag₂S, SnS, PbS, HgS.

12. The method according to any one of the preceding claims, wherein the chemical bath (BC) from which the thin layer (CM) is formed comprises a concentration of metal salt comprised between 0.001 mol.L⁻¹ and 1 mol.L⁻¹ and a thioacid concentration comprised between 0.001 mol.L⁻¹ and 0.5 mol.L⁻¹.

13. The method according to any one of the preceding claims, wherein the light source (S) has a power comprised between 100 and 2000 mW/cm².

14. A method for manufacturing a photo voltaic cell comprising a semiconductor layer with photo voltaic properties, the manufacturing method comprising obtaining said semiconductor layer with photovoltaic properties and depositing, on said semiconductor layer with photovoltaic properties, a semiconductor thin layer by means of the method according to any one of claims 1 to 13, so as to form a p-n junction of said photovoltaic cell.

15. An installation for implementing the method according to any one of the preceding claims, the installation comprising:
- a chemical bath (BC) containing at least one sulphur precursor of the at least one sulphide of a metal species and a salt containing said at least one metal species, the at least one sulphur precursor containing a thioacid of general formula R-COSH, encompassing prototropic forms of R-C(=O)SH type and of R-C(=S)OH type, where R designates a hydrogen or an organic group, and
- a light source (S) arranged to illuminate the chemical bath (BC).
